# EUROPEAN PATENT APPLICATION

(11) **EP 4 541 933 A1**
(43) Date of publication of application: **23.04.2025**
(21) Application number: 24196810.6
(22) Date of filing: 27.08.2024
(51) Int. Cl.: C23C 16/44

(54) **PASSAGE SYSTEM FOR EXHAUST GAS TO ABATEMENT APPARATUS**

(30) Priority: 01.09.2023 JP 2023142351
(71) Applicant: EBARA CORPORATION, Ota-ku, Tokyo 144-8510 (JP)
(72) Inventor: AOYAGI, Ryo, Tokyo, 1448510 (JP); MIYAZAKI, Kazutomo, Tokyo, 1448510 (JP); MATSUSHIMA, Keisuke, Tokyo, 1448510 (JP)
(74) Representative: Klang, Alexander H.

(57) **Abstract**

A passage system that can prevent leakage of exhaust gas delivered to an abatement reactor and can ensure safety is disclosed. The passage system includes: an exhaust-gas transfer pipe configured to deliver exhaust gas to an abatement reactor; a first two-way valve attached to the exhaust-gas transfer pipe; a bypass pipe that branches off from the exhaust-gas transfer pipe at a position upstream of the first two-way valve and bypasses the abatement reactor; and a second two-way valve attached to the bypass pipe. The first two-way valve and the second two-way valve are vertically positioned and have flow passages for the exhaust gas extending in a vertical direction.

## Description

### BACKGROUND OF THE INVENTION

### Field of the Invention:

The present invention relates to a passage system for delivering exhaust gas discharged from a processing chamber of a semiconductor manufacturing apparatus, such as an etching device or a CVD device, to an abatement reactor, and more particularly to a passage system having a flow-path switching function.

### Description of the Related Art:

In process of manufacturing semiconductor devices, liquid crystal panels, LEDs, etc., a process gas is introduced into a vacuum processing chamber for various processes, such as etching and CVD. The processing chamber and a vacuum evacuation system coupled to the processing chamber are periodically cleaned by passing a cleaning gas therethrough. Exhaust gas, such as the process gas or the cleaning gas, contain silane gas, halogen gas, PFC gas, etc., and can have adverse effects on human body and global environment, such as global warming. Therefore, the exhaust gas cannot be released as it is into the atmosphere. Therefore, the exhaust gas is released into the atmosphere after being detoxified by an abatement reactor (or a detoxification reactor) installed downstream of a semiconductor manufacturing apparatus.

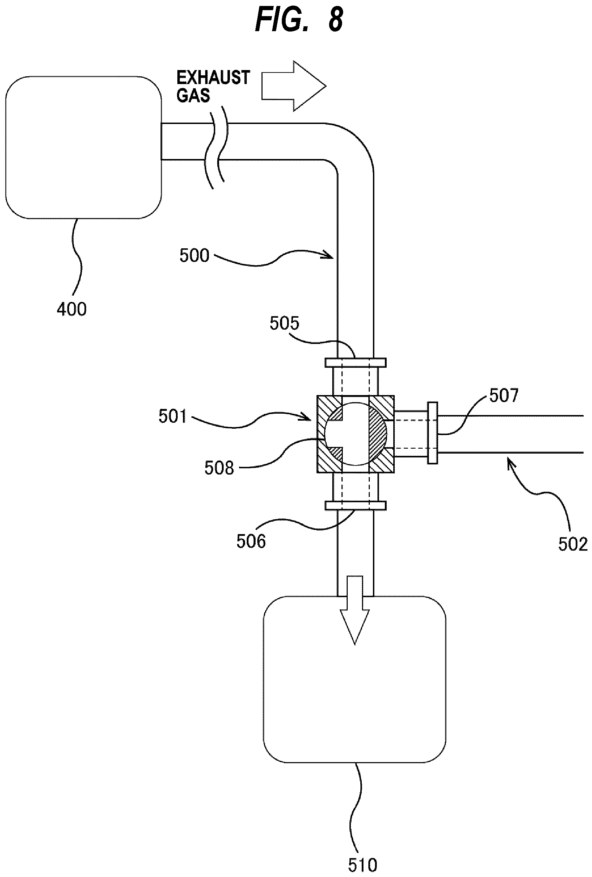

FIG. 8 is a schematic diagram showing an example of a passage system for delivering the exhaust gas from a processing chamber of a semiconductor manufacturing apparatus to an abatement reactor. The exhaust gas, such as the process gas or the cleaning gas, is discharged from a processing chamber 400 by a vacuum pump (not shown) and delivered to an abatement reactor 510 through an exhaust-gas transfer pipe 500. A three-way valve 501 composed of a ball valve is arranged in the exhaust-gas transfer pipe 500. An inlet 505 and a first outlet 506 of the three-way valve 501 are coupled to the exhaust-gas transfer pipe 500, and a second outlet 507 of the three-way valve 501 is coupled to a bypass pipe 502 that bypasses the abatement reactor 510. A valve element 508 of the three-way valve 501 operates to allow the inlet 505 to communicate with either the first outlet 506 or the second outlet 507.

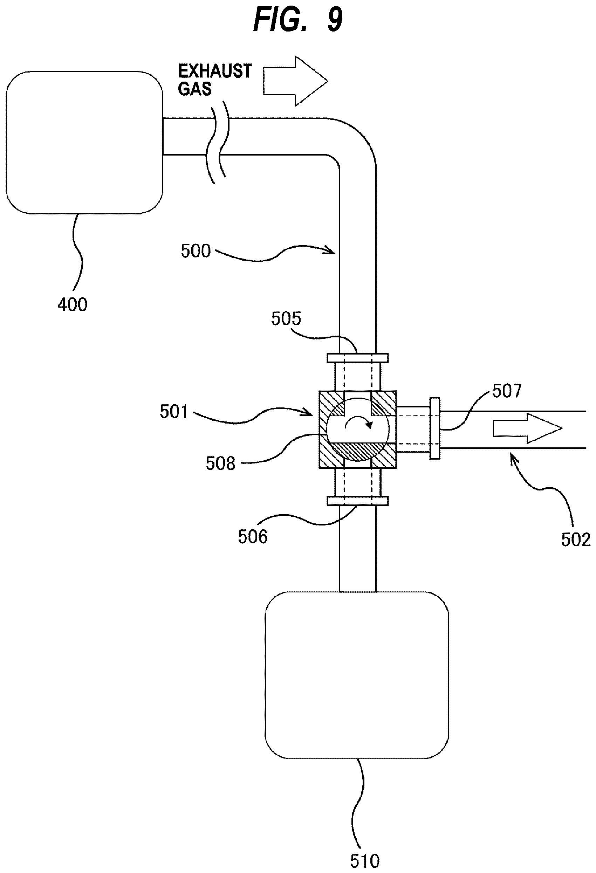

When the abatement reactor 510 is operating normally, the inlet 505 and the first outlet 506 of the three-way valve 501 are in communication with each other, and the exhaust gas is delivered to the abatement reactor 510 through the three-way valve 501, as shown in FIG. 8. On the other hand, when a serious malfunction has occurred in the abatement reactor 510 or when the abatement reactor 510 has stopped, the valve element 508 of the three-way valve 501 is operated to block the communication between the inlet 505 and the first outlet 506 of the three-way valve 501, while providing a fluid communication between the inlet 505 and the second outlet 507, as shown in FIG. 9. As a result, the exhaust gas is delivered to the bypass pipe 502 without being delivered to the abatement reactor 510.

### Citation List

### Patent Literature

Patent document 1: Japanese laid-open patent publication No. 2022-170680

The process gas and the cleaning gas used in the semiconductor manufacturing process may form particles (e.g., SiO₂) which are sublimation by-product. If the particles in the exhaust gas are deposited on the valve element 508 of the three-way valve 501, the valve element 508 may not operate normally or a sealing capability of the three-way valve 501 may be impaired. In particular, when the valve element 508 rotates, a flow passage formed in the valve element 508 moves across a sealing surface, so that the particles are likely to be caught between the valve element 508 and the sealing surface, and the sealing capability may be lost. As a result, there is a risk that a part of the exhaust gas is not delivered to the abatement reactor 510 and is released into the atmosphere through the bypass pipe 502.

In order to prevent deposition of the sublimation by-product, a jacket heater may be attached to the three-way valve 501 to heat the inside of the three-way valve 501 to a temperature above a sublimation temperature (e.g., 200°C). However, this entails a temperature change between a high temperature above the sublimation temperature and a room temperature, which can cause contraction of resin seal member or rubber seal member of the three-way valve 501 due to thermal history. As a result, a necessary sealing-surface pressure cannot be ensured, and leakage of the exhaust gas may occur.

### SUMMARY OF THE INVENTION

Therefore, the present invention provides a passage system that can prevent leakage of exhaust gas delivered to an abatement reactor and can ensure safety.

In an embodiment, there is provided a passage system comprising: an exhaust-gas transfer pipe configured to deliver exhaust gas to an abatement reactor; a first two-way valve attached to the exhaust-gas transfer pipe; a bypass pipe that branches off from the exhaust-gas transfer pipe at a position upstream of the first two-way valve and bypasses the abatement reactor; and a second two-way valve attached to the bypass pipe, the first two-way valve and the second two-way valve being vertically positioned and having flow passages for the exhaust gas extending in a vertical direction.

In an embodiment, the exhaust-gas transfer pipe has a vertical segment extending in the vertical direction, the bypass pipe has an ascending segment extending upwardly, the first two-way valve is disposed in the vertical segment, and the second two-way valve is disposed in the ascending segment.

In an embodiment, the second two-way valve is located higher than the first two-way valve.

In an embodiment, the passage system further comprises an inert-gas supply line configured to supply an inert gas into the bypass pipe, the inert-gas supply line being coupled to the bypass pipe at a position below the second two-way valve.

In an embodiment, the passage system further comprises a heating device configured to heat the inert gas in the inert-gas supply line.

In an embodiment, each of the first two-way valve and the second two-way valve is a ball valve.

According to the present invention, the combination of the first two-way valve and the second two-way valve is used instead of a three-way valve. The first two-way valve and the second two-way valve are vertically positioned and have their respective flow passages for the exhaust gas extending in the vertical direction. With these arrangements, particles (e.g., SiO₂) in the exhaust gas are unlikely to accumulate in the first two-way valve and the second two-way valve, and a normal operation of the first two-way valve and the second two-way valve can be maintained. In particular, the particles in the exhaust gas hardly reaches the second two-way valve. As a result, leakage of the exhaust gas through the first two-way valve and the second two-way valve is prevented, and safety can be ensured.

### BRIEF DESCRIPTION OF THE DRAWINGS

FIG. 1 is a schematic diagram illustrating an embodiment of a flow passage system for delivering exhaust gas from a processing chamber of a semiconductor manufacturing apparatus to an abatement reactor;
FIG. 2 is a cross-sectional view showing an embodiment of a first two-way valve;
FIG. 3 is a cross-sectional view showing a state in which the first two-way valve is closed;
FIG. 4 is a schematic diagram showing another embodiment of the passage system;
FIG. 5 is a schematic diagram showing still another embodiment of the passage system;
FIG. 6 is a schematic diagram showing still another embodiment of the passage system;
FIG. 7 is a schematic diagram showing still another embodiment of the passage system;
FIG. 8 is a schematic diagram showing a conventional example of a passage system for delivering exhaust gas from a processing chamber of a semiconductor manufacturing apparatus to an abatement reactor; and
FIG. 9 is a diagram showing an operation of a three-way valve when delivering the exhaust gas to a bypass pipe.

### DESCRIPTION OF EMBODIMENTS

Hereinafter, embodiments of the present invention will be described with reference to the drawings.

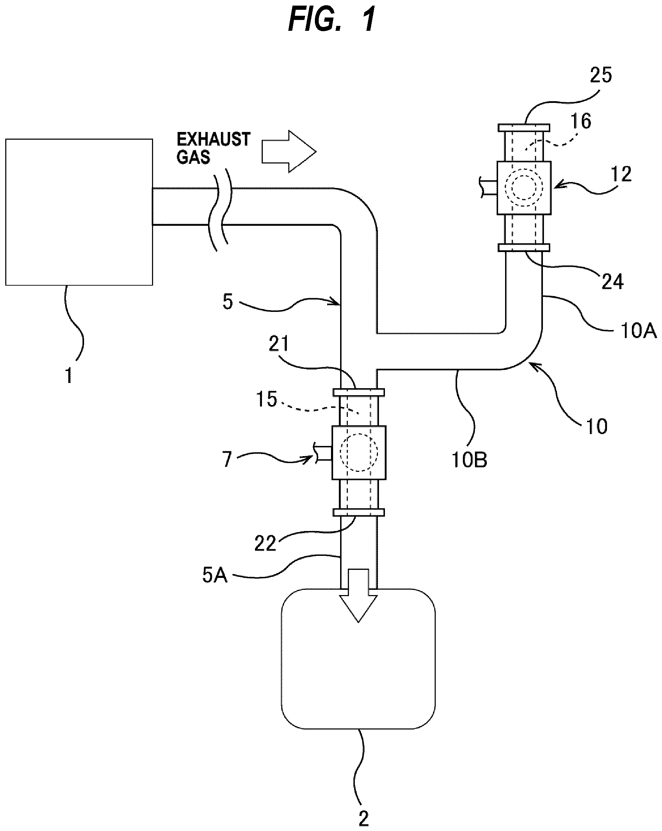

FIG. 1 is a schematic diagram showing an embodiment of a passage system for delivering exhaust gas from a processing chamber of a semiconductor manufacturing apparatus to an abatement reactor. Examples of the processing chamber include a processing chamber provided in a semiconductor manufacturing apparatus, such as an etching apparatus or a CVD apparatus.

As shown in FIG. 1, exhaust gas, such as a process gas or a cleaning gas, is exhausted from a processing chamber 1 by a vacuum pump (not shown) and delivered to an abatement reactor 2 through the passage system. The abatement reactor 2 is configured to render the exhaust gas harmless. Examples of the abatement reactor 2 include a combustion abatement reactor, a thermal plasma abatement reactor, and a heater-type abatement reactor.

The passage system includes an exhaust-gas transfer pipe 5 configured to deliver the exhaust gas discharged from the processing chamber 1 to the abatement reactor 2, a first two-way valve 7 attached to the exhaust-gas transfer pipe 5, a bypass pipe 10 branching off from the exhaust-gas transfer pipe 5 at a position upstream of the first two-way valve 7 and bypassing the abatement reactor 2 , and a second two-way valve 12 attached to the bypass pipe 10. During abatement treatment on the exhaust gas, the first two-way valve 7 is opened and the second two-way valve 12 is closed. Therefore, the exhaust gas is delivered to the abatement reactor 2 through the first two-way valve 7. When a serious malfunction occurs in the abatement reactor 2 or when the operation of the abatement reactor 2 is stopped due to an unexpected event, the first two-way valve 7 is closed and the second two-way valve 12 is opened. As a result, the exhaust gas flows through the bypass pipe 10 and the second two-way valve 12.

Each of the first two-way valve 7 and the second two-way valve 12 is an on-off valve having a single inlet and a single outlet. The first two-way valve 7 and the second two-way valve 12 are positioned vertically, with their respective flow passages formed therein extending in a vertical direction. Specifically, the first two-way valve 7 has a first flow passage 15 therein through which the exhaust gas flows, and the first flow passage 15 extends in the vertical direction. The second two-way valve 12 has a second flow passage 16 therein through which the exhaust gas flows, and the second flow passage 16 extends in the vertical direction. In this specification, the "vertical direction" includes directions within an angle range of 0 to 45 degrees with respect to a direction of gravity. The direction at an angle of 0 degrees is the direction of gravity.

In the present embodiment shown in FIG. 1, the first flow passage 15 of the first two-way valve 7 extends in the direction of gravity. The first two-way valve 7 has an inlet 21 and an outlet 22 for the exhaust gas, and the inlet 21 is located above the outlet 22. The exhaust-gas transfer pipe 5 has a vertical segment 5A extending in the vertical direction, and the first two-way valve 7 is disposed in the vertical segment 5A. In the present embodiment, the vertical segment 5A extends in the direction of gravity.

The second flow passage 16 of the second two-way valve 12 extends in the direction of gravity. The second two-way valve 12 has an inlet 24 and an outlet 25 for the exhaust gas, and the inlet 24 is located below the outlet 25. The bypass pipe 10 has an ascending segment 10A extending upwardly. The second two-way valve 12 is disposed in the ascending segment 10A. In this embodiment, the ascending segment 10A extends in the direction of gravity. The bypass pipe 10 further has a connecting segment 10B branching off from the exhaust-gas transfer pipe 5. One end of the connecting segment 10B is coupled to the exhaust-gas transfer pipe 5, and the other end of the connecting segment 10B is coupled to the ascending segment 10A. In the embodiment shown in FIG. 1, the connecting segment 10B extends horizontally. In one embodiment, the connecting segment 10B may extend obliquely upward or may be curved upward from the exhaust-gas transfer pipe 5 to the ascending segment 10A.

The first two-way valve 7 and the second two-way valve 12 are positioned vertically with their flow passages 15, 16 for the exhaust gas extending in the vertical direction, so that particles (e.g., SiO₂) in the exhaust gas are unlikely to accumulate in the first two-way valve 7 and the second two-way valve 12, and normal operations of the first two-way valve 7 and the second two-way valve 12 can be maintained. In particular, the second two-way valve 12 is located higher than the first two-way valve 7, and the second two-way valve 12 is disposed in the ascending segment 10A of the bypass pipe 10, so that the particles are unlikely to reach the second two-way valve 12.

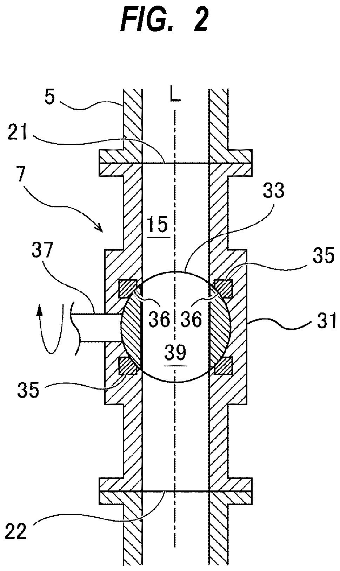

The first two-way valve 7 and the second two-way valve 12 are ball valves. The first two-way valve 7 will be described below with reference to FIG. 2. FIG. 2 is a cross-sectional view showing an embodiment of the first two-way valve 7. Although not shown, the second two-way valve 12 has the same basic configuration as the first two-way valve 7, and the following descriptions can be applied to the second two-way valve 12 as well.

As shown in FIG. 2, the first two-way valve 7 includes a valve housing 31 having therein the first flow passage 15 that allows the exhaust gas to pass therethrough, a ball-shaped valve element 33 arranged in the valve housing 31, seal members 35 that seal a gap between the valve housing 31 and the valve element 33, and a rotational shaft 37 configured to rotate the valve element 33 within the valve housing 31. The rotational shaft 37 is coupled to the valve element 33. Each seal member 35 has a sealing surface 36 that is in contact with an outer surface of the valve element 33.

The first two-way valve 7 has the inlet 21 and the outlet 22 for the exhaust gas. The inlet 21 is formed from one end of the first flow passage 15, and the outlet 22 is formed from the other end of the first flow passage 15. The valve element 33 has a movable flow passage 39 therein. When the valve element 33 is rotated by the rotational shaft 37, the movable flow passage 39 communicates with the first flow passage 15 as shown in FIG. 2, so that the exhaust gas can pass through the first flow passage 15 and the movable flow passage 39 of the first two-way valve 7. The first flow passage 15 extends in the direction of gravity L. Therefore, the particles, which are by-product contained in the exhaust gas, fall due to their gravity and are unlikely to accumulate in the first two-way valve 7.

The rotational shaft 37 is coupled to an actuator (not shown). When the actuator rotates the rotational shaft 37, a direction of the movable flow passage 39 formed in the valve element 33 can be changed, i.e., the first two-way valve 7 can be opened or closed. FIG. 2 shows the first two-way valve 7 in an open state.

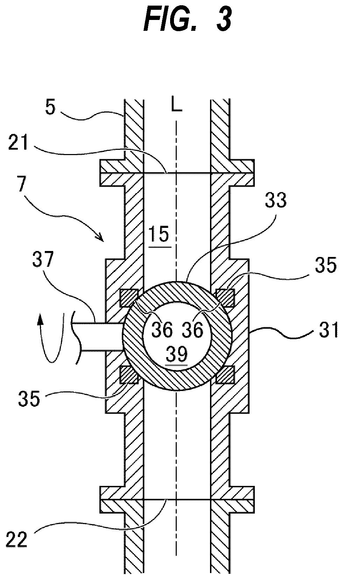

FIG. 3 is a diagram showing a state in which the first two-way valve 7 is closed. As shown in FIG. 3, the actuator (not shown) rotates the rotational shaft 37 to block the communication between the movable flow passage 39 in the valve element 33 and the first flow passage 15, so that the first two-way valve 7 is closed. As can be seen from FIGS. 2 and 3, when the valve element 33 is rotated in the valve housing 31, the movable flow passage 39 does not move across the sealing surfaces 36 of the seal members 35. Therefore, the particles in the exhaust gas are unlikely to be caught between the outer surface of the valve element 33 and the sealing surfaces 36. As a result, smooth operation of the valve element 33 can be ensured, sealing capability can be maintained, and leakage of the exhaust gas can be prevented.

The above explanation with reference to FIGS. 2 and 3 is applied to the second two-way valve 12 as well. Therefore, smooth operation of the valve element of the second two-way valve 12 can be ensured, sealing capability can be maintained, and leakage of the exhaust gas can be prevented.

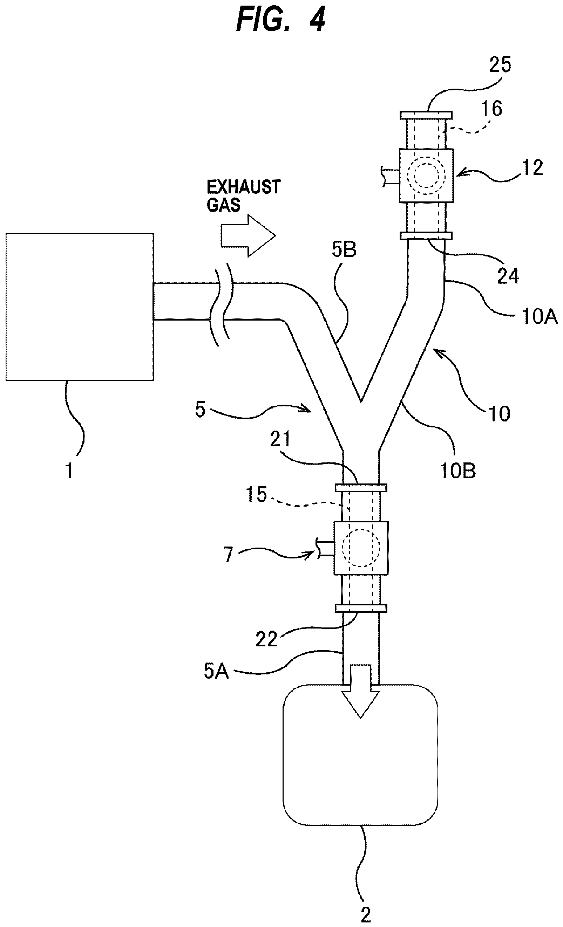

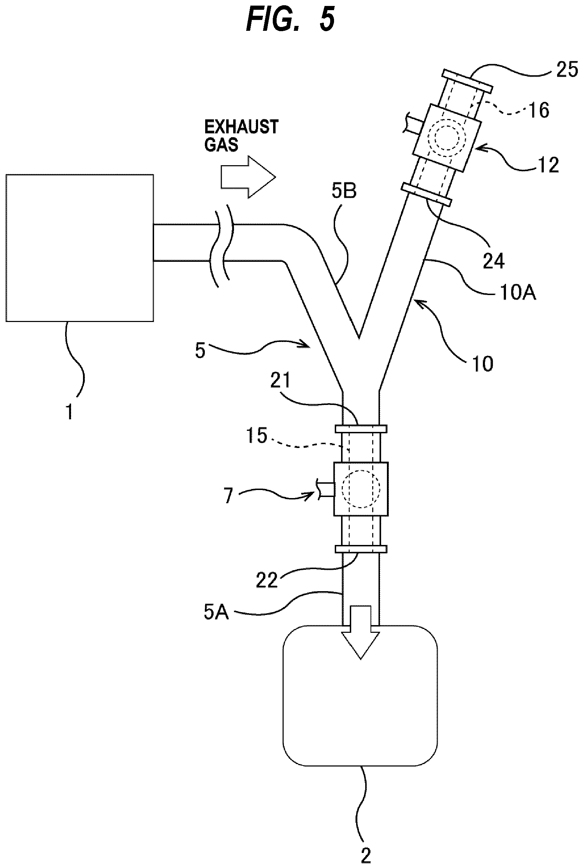

FIGS. 4 and 5 are schematic diagrams showing another embodiment of the passage system. Configuration and operation of this embodiment that will not be particularly described are the same as those of the above embodiments described with reference to FIGS. 1 to 3, and their repetitive descriptions will be omitted. As shown in FIGS. 4 and 5, the exhaust-gas transfer pipe 5 and the bypass pipe 10 may be composed of a Y-shaped pipe.

In the embodiment shown in FIG. 4, the exhaust-gas transfer pipe 5 has an upstream segment 5B extending obliquely. The first two-way valve 7 is attached to the vertical segment 5A extending in the direction of gravity. The upstream segment 5B is a part of the exhaust-gas transfer pipe 5 and is located upstream of the vertical segment 5A. The bypass pipe 10 includes a connecting segment 10B extending obliquely upward from the exhaust-gas transfer pipe 5 and an ascending segment 10A extending in the direction of gravity from the connecting segment 10B. The second two-way valve 12 is attached to the ascending segment 10A. In the embodiment shown in FIG. 4, both the first two-way valve 7 and the second two-way valve 12 are positioned in the direction of gravity. Specifically, the first flow passage 15 of the first two-way valve 7 and the second flow passage 16 of the second two-way valve 12 extend in the direction of gravity.

In the embodiment shown in FIG. 5, configurations and arrangements of the exhaust-gas transfer pipe 5 and the first two-way valve 7 are the same as those of the embodiment shown in FIG. 4, but configuration of the bypass pipe 10 and arrangement of the second two-way valve 12 are different from those of the embodiment shown in FIG. 4. Specifically, the bypass pipe 10 has an ascending segment 10A extending obliquely upward from the exhaust-gas transfer pipe 5, and the second two-way valve 12 is attached to the ascending segment 10A. A lower end of the ascending segment 10A is coupled to the exhaust-gas transfer pipe 5, and an upper end of the ascending segment 10A is coupled to the second two-way valve 12. The second two-way valve 12 is disposed obliquely. More specifically, the second flow passage 16 of the second two-way valve 12 is inclined with respect to the direction of gravity at an angle larger than 0 degrees and equal to or smaller than 45 degrees. In this embodiment also, the ascending segment 10A extends in the vertical direction, so that the particles in the exhaust gas are unlikely to reach the second two-way valve 12.

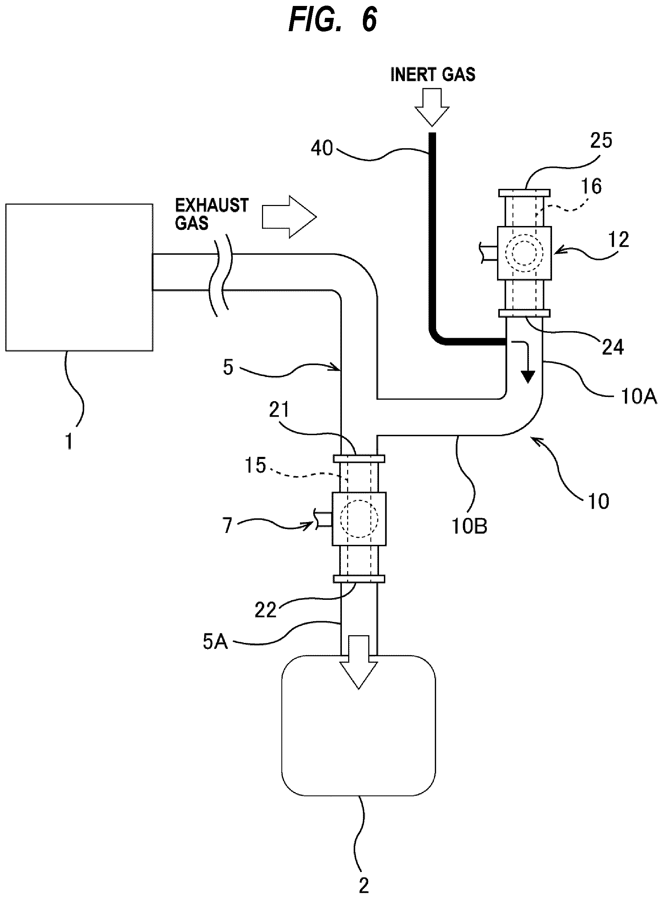

FIG. 6 is a schematic diagram showing yet another embodiment of the passage system. Configuration and operation of this embodiment that will not be specifically described are the same as those of the above embodiments described with reference to FIGS. 1 to 5, and their repetitive descriptions will be omitted. As shown in FIG. 6, the passage system further includes an inert-gas supply line 40 configured to supply an inert gas into the bypass pipe 10. The inert-gas supply line is coupled to the bypass pipe 10 at a position below the second two-way valve 12. The inert-gas supply line 40 is coupled to an inert-gas supply source (not shown). Examples of the inert gas include nitrogen gas.

The inert gas flows through the inert-gas supply line 40 into the bypass pipe 10 at a position below the second two-way valve 12. Furthermore, the inert gas flows through the bypass pipe 10 into the exhaust-gas transfer pipe 5. The downward flow of the inert gas in the bypass pipe 10 can prevent the particles in the exhaust gas from reaching the second two-way valve 12. Furthermore, the inert gas can reduce a concentration of the exhaust gas in the exhaust-gas transfer pipe 5 and the bypass pipe 10 and can therefore reduce the sublimation temperature. As a result, the particles of sublimation by-product are less likely to accumulate in the first two-way valve 7 and the second two-way valve 12.

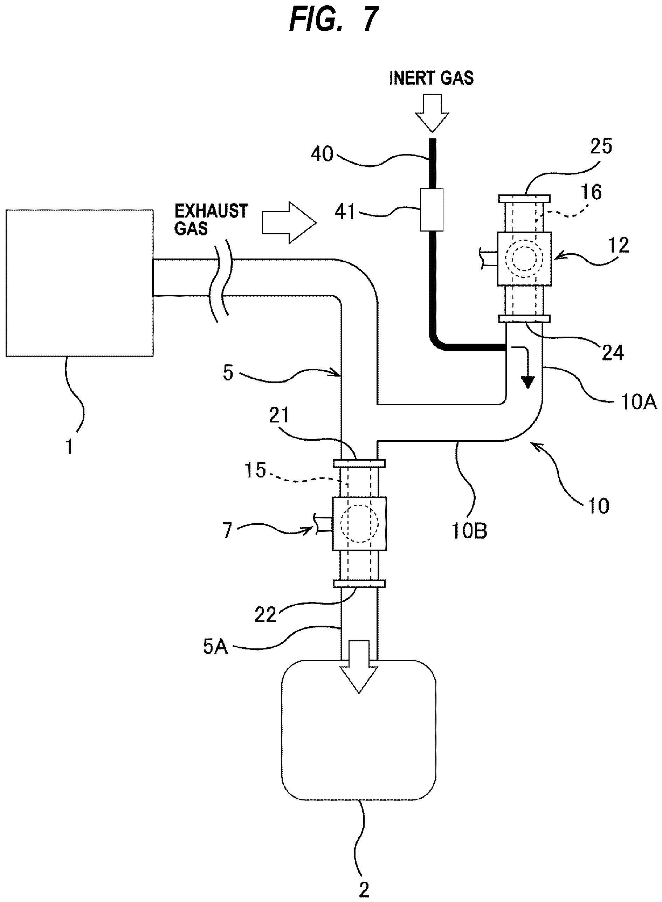

In another embodiment shown in FIG. 7, the flow passage system further includes a heating device 41 configured to heat the inert gas in the inert-gas supply line 40. The heating device 41 is attached to the inert-gas supply line 40 and is configured to heat the inert gas flowing through the inert-gas supply line 40. For example, the heating device 41 is configured to heat the inert gas to a temperature equal to or higher than the sublimation temperature of the by-product of the exhaust gas (e.g., 200°C). Specific configuration of the heating device 41 is not particularly limited. For example, an electric heater can be used as the heating device 41.

The heated inert gas can increase the temperature of the exhaust gas in the exhaust-gas transfer pipe 5 and the bypass pipe 10. Therefore, the particles of sublimation by-product are less likely to be formed. As a result, smooth operations of the valve elements 33 of the first two-way valve 7 and the second two-way valve 12 can be ensured, the sealing capability can be maintained, and leakage of the exhaust gas can be prevented.

The embodiments of the inert-gas supply line 40 and the heating device 41 described with reference to FIGS. 6 and 7 are applicable to the embodiments described with reference to FIGS. 4 and 5.

In each of the above-described embodiments, the first two-way valve 7 and the second two-way valve 12, which are on-off valves, are ball valves each having the ball-shaped valve element 33. In one embodiment, the first two-way valve 7 and the second two-way valve 12 may be on-off valves other than ball valves, such as globe valves, needle valves, diaphragm valves, or gate valves. However, the ball valves are preferable because the valve element is less likely to catch the particles.

The previous description of embodiments is provided to enable a person skilled in the art to make and use the present invention. Moreover, various modifications to these embodiments will be readily apparent to those skilled in the art, and the generic principles and specific examples defined herein may be applied to other embodiments. Therefore, the present invention is not intended to be limited to the embodiments described herein but is to be accorded the widest scope as defined by limitation of the claims.

## Claims

1. A passage system comprising:
an exhaust-gas transfer pipe configured to deliver exhaust gas to an abatement reactor;
a first two-way valve attached to the exhaust-gas transfer pipe;
a bypass pipe that branches off from the exhaust-gas transfer pipe at a position upstream of the first two-way valve and bypasses the abatement reactor; and
a second two-way valve attached to the bypass pipe, the first two-way valve and the second two-way valve being vertically positioned and having flow passages for the exhaust gas extending in a vertical direction.

2. The passage system according to claim 1, wherein
the exhaust-gas transfer pipe has a vertical segment extending in the vertical direction,
the bypass pipe has an ascending segment extending upwardly,
the first two-way valve is disposed in the vertical segment, and
the second two-way valve is disposed in the ascending segment.

3. The passage system according to claim 1, wherein the second two-way valve is located higher than the first two-way valve.

4. The passage system according to claim 1, further comprising an inert-gas supply line configured to supply an inert gas into the bypass pipe, the inert-gas supply line being coupled to the bypass pipe at a position below the second two-way valve.

5. The passage system according to claim 4, further comprising a heating device configured to heat the inert gas in the inert-gas supply line.

6. The passage system according to claim 1, wherein each of the first two-way valve and the second two-way valve is a ball valve.
